(19) Europäisches Patentamt
European Patent Office
Office européen des brevets

(11) **EP 2 919 275 B1**

(12) **EUROPEAN PATENT SPECIFICATION**

(45) Date of publication and mention
of the grant of the patent:
**18.08.2021 Bulletin 2021/33**

(51) Int Cl.:
***H01L 31/05*** *(2014.01)*

(21) Application number: **14000909.3**

(22) Date of filing: **13.03.2014**

(54) **Solar cell interconnector, solar cell array and method of interconnecting solar cells of a solar cell array**

Solarzellenverbinder, Solarzellenanordnung und Verfahren zum Verbinden von Solarzellen einer Solarzellenanordnung

Interconnecteur de cellule solaire, cellule solaire et procédé d'interconnexion de réseau de cellules solaires d'un réseau de cellules solaires

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**16.09.2015 Bulletin 2015/38**

(73) Proprietor: **Airbus Defence and Space GmbH 82024 Taufkirchen (DE)**

(72) Inventors:
• **Zimmermann, Claus**
  **D-81371 München (DE)**
• **Steins, Wiebke**
  **85737 Ismaning (DE)**

• **Meurer, René**
  **83052 Bruckmühl (DE)**

(74) Representative: **Schicker, Silvia Wuesthoff & Wuesthoff Patentanwälte PartG mbB Schweigerstraße 2 81541 München (DE)**

(56) References cited:
WO-A1-2012/081382    DE-A1-102008 050 332
US-A- 3 553 030      US-A- 4 562 637
US-A- 5 391 235      US-A- 5 679 176
US-A1- 2007 283 997  US-A1- 2008 314 432
US-A1- 2009 159 119  US-A1- 2012 103 386
US-A1- 2013 048 336  US-B1- 6 184 457

**Description**

FIELD OF THE INVENTION

The present invention is directed to a solar cell array of at least two solar cells electrically interconnected with a solar cell interconnector with at least two layers. The invention is further directed to a method of interconnecting solar cells of such a solar cell array with said interconnectors.

BACKGROUND OF THE INVENTION

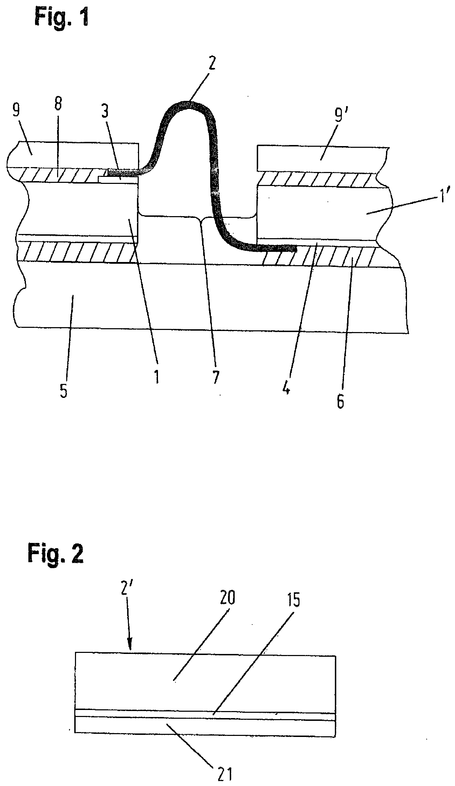

Solar cells are the primary source of electrical power generation in space. For realizing the required operational voltage, numerous solar cells are typically connected in series, called a "string". Fig. 1 shows an example of a series connection of solar cells 1,1' into a string of cells by means of a thin S-shaped metal foil interconnector 2. The stress expansion loop of the interconnector significantly protrudes above the cover glasses 9, 9' covering the solar cells 1,1'. The solar cells 1,1' are interconnected via interconnectors 2, which are applied by welding or soldering to solar cell contacts 3 provided on the front side and solar cell contacts 4 provided on the rear side of the respective solar cell 1, 1'. The interconnectors 2 are typically manufactured by a chemical etching process or by mechanical stamping out of thin metal foils in the range of 10 to 30 $\mu$m thickness. To avoid inducing an electrical resistance which decreases the power output, these interconnectors need to be sufficiently electrically conductive to prevent an unacceptable voltage drop.

Furthermore, in space applications, the strings are usually bonded with a silicon adhesive 6 to a sandwich panel 5 with carbon fiber facesheet and an aluminum honeycomb core with a polymer frontside insulation. For radiation protection, a cover glass 9,9' is bonded to the solar cell 1,1' with transparent silicone adhesive 8. These substrates have a large thermal expansion mismatch relative to the solar cell 1, 1'. During eclipse phases with temperature fluctuations up to 200 °C, the gap 7 between two solar cells 1, 1', inside one string, varies by several 10 $\mu$m, which leads to significant thermo-mechanical stress in the interconnector material. To cope with this, it is state of the art to use 10 to 30 $\mu$m thick metal foils like Ag or Au, both of which might have some additives for strengthening. The advantage of these two materials is, next to the good electrical conductivity, that they can be welded directly onto the Ag cell contacts. However, for such high conductive materials, the actual thickness for interconnector application is higher than required from an electrical point of view. Depending on interconnector geometry and welding area, only a few micrometers would be sufficient. This higher thickness eases the handling and production processes, however decreases the overall lifetime, as the thickness contributes linearly to the resulting stress, which is largest in the highest, loop-like portion of the interconnector.

Other materials often used as interconnector materials are Mo, a nickel-cobalt ferrous alloy (e.g. known under the trade names KOVAR) or a nickel-iron alloy (e.g. known under the trade name INVAR). The low coefficient of thermal expansion of these materials reduces the contribution of the thermal expansion of the interconnector to the overall gap variation making them good candidates for missions with several 10.000 eclipse phases, i.e. in a low earth orbit. As these materials cannot be welded or soldered directly to the solar cell contacts, however, they are additionally plated with several $\mu$m of Ag or Au, which makes the manufacturing process sensitive and expensive.

The second main requirement that an ideal interconnector has to fulfil is a high resistance against erosion by energetic Xe ions. These ions, with energies in the range of some 100 eV, are emitted by electric thrusters used for station keeping and increasingly also for the orbit rising of satellites. In this energy range all metallic materials exhibit a non-negligible sputtering yield, defined as the number of sputtered atoms per incident ion. It is known from the non-patent literature "M. Tartz, T. Heyn, C. Bundesmann, C. Zimmermann, and H. Neumann, Sputter yields of Mo, Ti, W, Al, Ag under xenon ion incidence, Eur. Phys. J. D 61, 587-592 (2011)" that typical values are ranging from 0.12 for 200 eV Xe impinging on Ti, to 0.3 for the combination Al/Xe to 1.3 for Ag/Xe . This sputtering yield further increases at non-normal angles of incidence.

The geometric shape of the interconnector is designed to minimize internal stresses during cycling and therefore the interconnectors 2 are usually S-shaped, which makes them significantly protruding above the cell cover glasses 9, 9'. Especially this protruding part is exposed to the Xe ions and presents itself at a wide range of incidence angles. This will result in a non-homogeneous erosion profile and detrimental stress concentration. Of course, it is possible to select interconnector materials like Al or Ti, which have a lower sputter yield than Ag, for example. But even in this case, significant material is sputtered away and redeposition of material at solar cell edges can present a reliability risk by providing an electric shunt path.

For all materials an increase in interconnector thickness is thus no viable option and in addition would increase the thermo-mechanical stresses and reduce fatigue life, as mentioned before. In conclusion, all possible metallic interconnector materials only have a limited tolerance to Xe erosion before the reliability of the solar array is negatively affected.

Accordingly, there is still a demand for highly electrical conductive foil materials having an improved thermo-mechanical cycling stability combined with an improved Xe ion erosion resistance.

EP 0 758 145 A2 describes a connection process for manufacturing a circuit module by performing connection between an external electrode of a component and a conductor of a transparent substrate by applying a laser beam through the substrate heating the connection spot to create phase transition and/or diffusion.

EP 1 305 988 A1 discloses a method for producing an electrical connection between a flexible circuit board with single sided access and a metallic contact partner comprising the steps of:

- providing a flexible circuit board, comprising two insulation layers and at least one metallic conductor strip running in between, wherein in the first insulating layer of which there is formed an access opening exposing the conductor strip;
- bringing the metallic contact partner and the circuit board toward each other in such a way that the metallic contact partner is brought to bear against the metallic conductor strip through the access opening;
- and irradiating the second insulating layer with laser light at a location lying opposite the access opening, wherein a welded connection being formed between the contact partner and the conductor strip.

US 6 983 539 B2 discloses a method of forming an electrical connection between a TAB (tape automated bonding) circuit and electrical contact bumps, the TAB circuit including a polymeric base and electrical leads formed on the polymeric base, said method comprising the steps of:

- aligning the electrical leads and of the TAB circuit with the electrical contact bumps;
- holding the electrical leads of the TAB circuit with the electrical contact bumps in contact at a bond surface, and
- bonding the electrical leads and the electrical contact bumps at the bond surface by directing a laser beam to propagate through the polymeric base of the TAB circuit to heat the electrical leads.

US 2007/283997 A1 discloses a photovoltaic device having a collector-connector, which comprises an electrically insulating carrier made of a flexible, electrically insulating polymer film, such as a thermal polymer olefin (e.g. polyethylene, polypropylene, polybutylene) and an electrical conductor (e.g. made of silver).

US 2013/048336 A1 is directed to a polymeric coated busbar adhesive tape for use in photovoltaic systems. The busbar tape includes a conductive metallic foil, on which a formulated protective polymeric coating is laminated. The polymer coating employs an anti-corrosion agent. Usually Cu, Al, W, Sn, and steel are used as metallic foil. The thickness of the metallic foil is 10 to 75 microns. The polymer coating is selected in view of sufficient adhesion to the copper foil and includes polyacrylates, polyurethanes, etc.. The glass transition temperature (Tg) of the protective polymer coating should be below 30°C in view of sufficient flexibility.

US 3,553,030 A discloses flexible supports that electrically interconnect solar cells. The supports comprise a flexible sheet of electrically insulating material having on one side metallized surface portions (Cu or Ag) with incisions. The flexible support forming the substrate of the panel is made of an insulating flexible material, such as polyimide resins. The metal film may have thickness of 15 $\mu$m.

US 6,184,457 B1 discloses a solar cell interconnector comprising a black PET tape as insulating member, on which a metal member is stuck. The insulating member has a thickness of 130 $\mu$m.

US 2008/314432 A1 discloses a flexible electrically insulating polymer film having a sheet or ribbon shape made of thermal polymer olefin (e.g. polyethylene, polypropylene, polybutylene) and a conductor comprising Cu or Al.

US 4,562,637 A discloses a solar battery on whose elements a film is formed with a conductive pattern of copper foil having solder deposited thereon.

US 2009/159119 A1 discloses a transparent moisture barrier material layer comprising a polymer material such as polyethylene, polypropylene, polystyrene, polyimide, etc. and an inorganic material such as silicon or aluminum oxides .

US 5,391,235 A refers to a conductive member comprising an insulating material such as polyester, polyimide, polyethylene, nylon, etc. and a metal foil made of Cu, Au, Ag, Al, Sn or solder. The thickness of the insulating member is between 20 and 200 $\mu$m.

DE 10 2008 050 332 A1 discloses a multiple layer foil comprising a transparent flexible polymer layer as a carrier layer made of PET or BOPP having a thickness of 19-150 $\mu$m, an additional layer made of ITO with a thickness of 50-120 nm and an electrode layer made of Ag and having a thickness of 5 to 50 $\mu$m. The multiple layer foil is deposited on the electrode layer and conversion layer and is thus part of the photovoltaic cell.

OBJECT OF THE INVENTION

Thus, it is a first object of the present invention to provide a high reliable solar cell array with a solar cell interconnector having an improved thermo-mechanical cycling stability with high electrical conductivity and being Xe ion erosion resistant as well as handling friendly. It is another object of the invention to provide a method of interconnecting solar cells with said interconnectors.

The solar cell interconnector used in the solar cell array of claim 1 comprises at least two layers, a first, substrate layer and a second, electrically conductive layer. The substrate layer is made of polyimide or ETFE and the electrically conductive layer consists of a metal material deposited on the substrate layer. One end portion of the solar cell interconnector is folded under 45° with the electrically conductive layer of a bent portion and a remaining portion of the solar cell interconnector coming into physical contact with one another. The electrically conductive layer of an end of the bent portion is arranged next to the remaining portion.

The present invention comprises a new bi-layer sandwich material for the use as solar cell interconnector particularly for space applications but not necessarily limited to space. This sandwich material is a combination of a substrate layer, e.g. a flexible thin polymer foil, and an electrically conductive layer placed on said substrate layer, e.g. a conductive metal film.

The solar cell interconnector provides superior resistance to erosion via sputtering, for example by Xe ions, and thermo-mechanical fatigue, while at the same time lending itself to flexible, laser based interconnection and structuring methods. The basic idea of the invention is thus to combine the elasticity features of the polymeric material of the substrate layer with the electrical conductivity features of the conductive layer in one single device.

It is advantageous when the material of the substrate layer comprises high yield strength properties, in particular a yield strength > 100 MPa.

In a preferred embodiment the material of the substrate layer comprises a low Young's modulus, in particular a Young's modulus < 10 MPa.

In yet another preferred embodiment the material, preferably a metal material, of the electrically conductive layer comprises a low electrical resistivity, in particular a resistivity less than $5\times10^{-6}$ Ohm. In other words, the electrically conductive layer has sufficient conductivity.

It is furthermore advantageous when the substrate layer is resistant against particle radiation and/or ultraviolet light radiation and/or vacuum exposure. This will increase reliability as well as durability of the interconnector. The resistance against particle radiation includes resistance against impinging ions, e.g. Xe ions emitted from electrical propulsion thrusters.

Preferably, the material of the electrically conductive layer is selected such that the thermal expansion coefficient of the electrically conductive layer is substantially the same as the thermal expansion coefficient of the substrate.

At the application date of this patent application suitable polyimides were, for example, known under the trade names "KAPTON" from DuPont or "UPILEX" from UBE Industries. A preferred polyimide is 1.1 poly(4,4'-oxydiphenylene-pyromellitimide) [trade names "KAPTON HN" or "KAPTON VN"]. Another preferred polyimide is 3,3',4,4'-biphenyl tetracarboxylic dianhydride/1,4-phenylenediamine (BPDA- PDA) [trade name "UPILEX-S"]. Another suitable polymer material for the solar cell interconnectors of the present application is ethylene tetrafluoroethylene (ETFE) [e.g. known under the trade name "TEFZEL" from DuPont].

The material of the electrically conductive layer is preferably Ag or Au or Au88/Ge12 or Al.

The substrate layer thickness is, in an advantageous embodiment of the invention, within a range of 5 to 50 $\mu$m, preferably within a range of 10 to 25 $\mu$m, most preferably 12.5 $\mu$m.

The electrically conductive layer thickness is preferably within a range of 1 to 10 $\mu$m, more preferably within a range of 1 to 5 $\mu$m.

It is very advantageous when the electrically conductive layer thickness is selected in order to minimize stresses in the electrically conductive layer for a given bending radius. This will enhance the durability and reliability of the interconnector.

One of a lot of advantageous practical examples is designed such that the electrically conductive layer thickness is 1.9 $\mu$m and the substrate layer thickness is 12.5 $\mu$m.

The object of the present invention directed to a solar cell array is achieved by a solar cell array with the features of claim 1.

This solar cell array according to the present invention is formed of two solar cells electrically interconnected with the above solar cell interconnector, the solar cells each having a first surface exposed to an ion source, wherein the solar cell interconnector is mounted to the solar cells in such a way that the respective substrate layer of each interconnector is directed to the ion source and forms thus an outer exposed surface area shielding the respective electrically conductive layer underneath from erosion due to sputtering. Such ions can, for example, be Xe ions from electric propulsion thrusters. The electrically conductive layer of the end of the bent portion arranged next to the remaining portion of the solar cell interconnector is electrically connected to a second surface of the respective solar cell opposite the first surface.

In another embodiment, it is advantageous when the solar cell interconnector is embedded in silicone.

A method of interconnecting solar cells of a solar cell array according to the invention is defined in claim 13.

This inventive method comprises the steps of

- providing a sandwich foil roll of a polymeric material substrate layer and an electrically conductive metal layer;
- welding a first spot of the electrically conductive metal layer to a first solar cell contact pad;
- laser cutting the polymeric material substrate layer on a side remote from the first welding spot;
- tearing off of the remaining sandwich foil and thus cutting the metal layer, thereby forming a solar cell interconnector;
- folding one end portion of the solar cell interconnector under 45° with the electrically conductive layer of a bent portion and a remaining portion of the solar cell interconnector coming into physical contact with one another, wherein the electrically conductive layer of an end of the bent portion being arranged next to the remaining portion; and
- welding a second spot of the electrically conductive metal layer to a second solar cell contact pad, wherein the second spot of the electrically conductive metal layer is at the end of the bent portion arranged next to the remaining portion.

The present invention provides a mechanical cycling stable, handling friendly and particularly Xe ion erosion resistant solar cell interconnector, which can be welded directly to the solar cell contacts.

The invention is hereinafter described by example with reference to the drawings. In these drawings

Fig. 1 depicts a solar cell array with interconnectors according to the prior art;
Fig. 2 is a schematic cross section of an example of a material sandwich of a solar cell interconnector according to the present application;
Fig. 3A shows a schematic cross section of a two layer beam;
FIG. 3B shows an equivalent cross section of a pure silver beam;
Fig. 4A shows a first example of a solar cell connector not part of the invention connecting two solar cells of a solar cell array;
Fig. 4B shows a second example of a solar cell connector according to the invention connecting two solar cells of a solar cell array;
Fig. 4C is a planar view of a welding area of a solar cell connector according to the invention welded to a solar cell in the direction of arrow C in Fig. 4B;
Fig. 5A shows a third example of a solar cell connector not part of the invention connecting two solar cells of a solar cell array;
Fig. 5B shows a fourth example of a solar cell connector according to the invention connecting two solar cells of a solar cell array;
Fig. 6 shows a diagram representing a transmission and reflection measurement on 25 $\mu$m "KAPTON HN" foil;
Fig. 7 shows a diagram representing reflection measurements on metallized "KAPTON" foil from the "KAPTON" side;
Fig. 8 shows an example of an automated interconnection method according to the invention.

## DETAILED DESCRIPTION OF THE INVENTION

Fig. 2 shows an example of a layer structure of a solar cell connector 2' according to the invention comprising a metallised polyimide foil consisting of a polyimide foil as a substrate layer 20 and an electrically conductive layer 21 of a metallic material. An intermediate layer 15 can be provided between the substrate layer 20 and the electrically conductive layer 21 as a thin undercoating.

Thus, the layer structure of a practical example consists of a polyimide film layer 20 coated with a conductive metal layer 21. It is, for example, a 7 $\mu$m to 25 $\mu$m thick "KAPTON HN" or "KAPTON VN" foil coated with 1 $\mu$m to 5 $\mu$m Ag, Au, Au88/Ge12 or Al, but is not limited neither to the stated thicknesses, nor to the stated materials and can also include a dedicated undercoating for the chosen conductive material as shown exemplarily in Fig. 2. Various pre-treatments of the polyimide of the substrate layer according to the state of the art can be applied to increase the adhesion of the metal layer.

Contrary to most fatigue test setups, the variation of the inter solar cell gap on a solar array due to temperature represents a strain controlled setup. For a given strain $\epsilon$ the resulting stress $\sigma$ is given by $E\epsilon$, where E denotes the materials Young's modulus. The Young's modulus of "KAPTON HN", as an example of polyimide, and different metallic materials that are commonly used as solar cell interconnectors are compared in Table 1. It can be seen that the Young's modulus of "KAPTON" is a factor 28 times lower than the next lowest value for a metallic material, in this case Ag. The stresses in the interconnector are reduced by the same amount. The yield strength, on the other hand, of "KAPTON" is 75 MPa and thus only approximately a factor 4 lower than the yield strength of most metals with low Young's modulus. In summary while the stresses in a metal interconnector can result in plastic deformation and consequently in a fatigue behaviour in the low cycle fatigue range, the ratio yield strength/Young's modulus of polyimide is one order of magnitude lower, and fatigue during typical space missions is of no concern.

**Table 1: Young's modulus of "KAPTON" and different metallic materials that are commonly used for solar cell interconnectors**

| Young's modulus (GPa; @ 23°C)) | | | | | |
|---|---|---|---|---|---|
| Kapton HN[1] | Ag [2] | Au [2] | Mo [2] | Invar [2] | Kovar |
| 2.5 | 71 | 78 | 320 | 150 | 159 |
| 1) Dupont Kapton HN Data Sheet<br>2) ASM International Metals Handbook, Volume 2, 10th edition | | | | | |

By creating a bilayer system according to Fig. 2, the superior fatigue properties of "KAPTON" can be combined with the high electrically conductivity of, for example, Ag, while at the same time subjecting the Ag layer to far lower stresses. Since the "KAPTON" layer provides mechanically support, the Ag layer can remain much thinner than the 10 $\mu$m to 30 $\mu$m required for a bare Ag interconnector.

In order to illustrate the reduction in stress levels, a beam with rectangular cross section is chosen as a model system, composed of this bilayer system. It is fixed at one end and deflected at the other end by a fixed amount such that bending radius of the beam remains the same, independent of its stiffness.

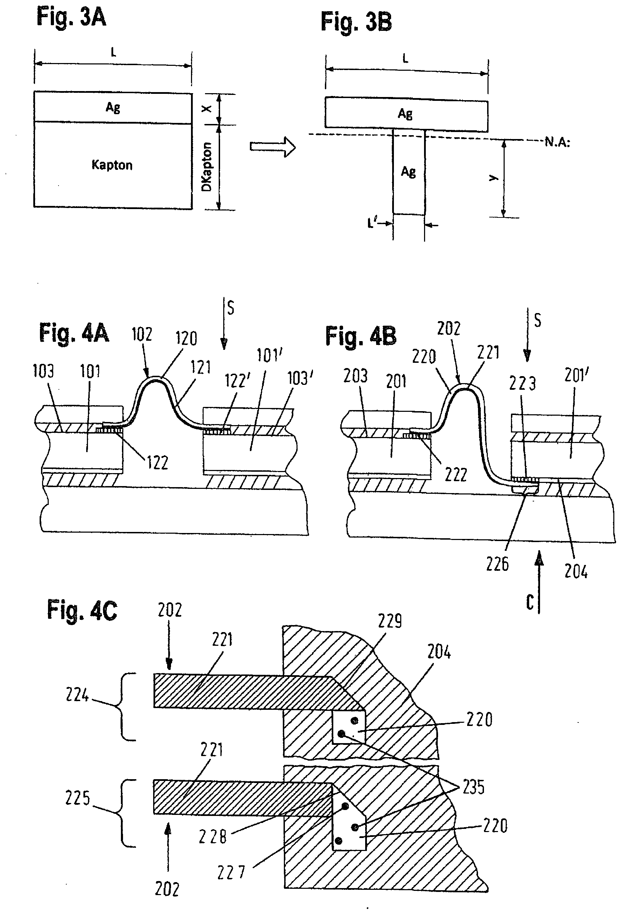

Fig. 3A shows a cross section of such a two layer beam and Fig. 3B shows an equivalent cross section of a pure silver beam.

The stresses in a bilayer beam of such composition can be estimated by an equivalent width technique as schematically illustrated in Fig. 3. For a given width L of the beam cross section, the "KAPTON" layer is treated as a Ag layer of smaller width L' according to the ratio R of the Young's modulus of silver $E_{Ag}$ and of "KAPTON" $E_{Kapton}$:

$$L' = \frac{L}{R}; R = \frac{E_{Ag}}{E_{Kapton}}$$

The location y of the stress free neutral fiber N.A. is calculated as

$$y = \frac{Lx(D_{Kapton} + x/2) + L'D_{Kapton}\, D_{Kapton}/2}{Lx + L'D_{Kapton}}$$

The maximum stress in the Ag layer for a given bending radius occurs at its outermost surface and depends linearly on its distance from the neutral fiber N.A. For any given "KAPTON" thickness $D_{Kapton}$, there is therefore an optimum Ag thickness x. For very small silver thicknesses, N.A. stays essentially in the middle of the "KAPTON" layer. Increasing x pushes N.A. closer to the silver layer. A certain point, however, if N.A. is already close to the silver layer increasing the silver layer thickness further only starts to increase the distance from the neutral fibre again. The optimum thickness x* is derived as

$$x^* = D_{Kapton} \frac{\sqrt{R-1}-1}{R}; R = \frac{E_{Ag}}{E_{Kapton}}$$

and the position of N.A. is then:

$$y(x^*) = D_{Kapton} \frac{R-1}{R}$$

For the example of a 12.5 $\mu$m thick "KAPTON" foil and the $E_{Ag}/E_{Kapton}$ ratio R of 28, the optimum Ag thickness is 1.9 $\mu$m and the neutral fibre is located 12.1 $\mu$m away from the bottom surface. The maximum stress is the same as in a 2*(1.9+0.4) $\mu$m = 4.6 $\mu$m pure Ag beam and thus more than 2.5 times lower than in a 12.5 $\mu$m pure Ag beam. Since N.A. is pushed almost to the surface of the "KAPTON" layer, the maximum stresses in the "KAPTON" layer are essentially doubled, but based on the argument above, that is still easily tolerable by the polyimide. In its application as a solar cell interconnector, the reduced stiffness of the bilayer interconnector compared to a pure metal one, in addition results in a larger portion of the interconnector being able to take up the stress due to inter cell gap variation.

In terms of electrical resistivity this layer thickness is more than sufficient. For an interconnector of a width w = 5 mm, and a length l = 5 mm, featuring x = 2 $\mu$m of Ag with a specific resistance p of $2 \times 10^{-8}$ $\Omega$m a resistance R, R = pl/wx, of 10 m$\Omega$ results. For a cell equipped with three interconnectors of this type and delivering 0.5 A of current, a voltage drop of less than 2 mV results.

The bilayer interconnector according to the present invention has not only superior fatigue resistance, but can also tolerate higher Xe ion fluences. The sputtering yield for "KAPTON" is a factor 4 lower than for Aluminum. According to the non-patent literature: "A.P. Yalin, B. Rubin, S.R. Domingue, Z. Glueckert, and J.D. Williams, Differential Sputter Yields Of Boron Nitride, Quartz, and Kapton Due to Low Energy Xe+ Bombardment, 43rd AIAA/ASME/SAE/ASEE Joint Propulsion Conference & Exhibit (doi: 10.2514/6.2007-5314)" the sputter yield for Kapton at 250 eV and perpendicular incidence is 0.008 mm$^3$/C. In contrast the sputter yield in Al of 0.3 atoms/ion translates into 0.03 mm$^3$/C. Therefore the "KAPTON" substrate layer can provide efficient protection to the metalized layer from Xe ion erosion, provided the interconnector is oriented appropriately.

Fig. 4A and Fig. 4B show two suitable interconnector configurations in which the "KAPTON" layer 120, 220 provides shielding to the metal layer 121, 221 from impinging ions.

The configuration in the example of Fig. 4A requires solar cells 101, 101' with contact spots 122, 122' of both polarities on the front side metallisation layers 103, 103' of the solar cells 101, 101'electrically connected via a solar cell interconnector 102 according to the invention.

In the example of Fig. 4B the solar cell interconnector 202 electrically connects contact spot 222 on the front side metallisation layer 203 and contact spot 223 on the cell rear side metallisation layer 204 of solar cells 201, 201'. As can be seen in Fig. 4B and Fig. 4C, the solar cell interconnector 202 electrically connecting solar cells 201 and 201' is turned upside down at contacting spot 223 in the protected space 226 underneath the cell in order to be connected to the cell rear side metallisation layer 204. The metal layer 221 of interconnector 202 is thus protected against impinging ions S either by the "KAPTON" layer 220 or by the solar cell 201' in the shadowed area of the solar cell 201' at space 226.

Fig 4C shows a planar view of contacting spot 223 as seen from the cell rear side (arrow C in Fig. 4B) with two alternative options of welding the solar cell interconnector of the invention to the cell rear side metallisation layer 204.

On most solar cells, a top contact design can be provided easily according to state of the art methods, as for example described in EP 1 693 899 A2. Contacts 122, 122' of both polarities are then on the front surface of the cell. In this case the interconnection is straightforward as shown in Fig. 4A. The "KAPTON" substrate layer 120 protects the metal layer 121 underneath against the ions S which hit the solar cell array.

But also solar cells with contacts on top and bottom can be safely interconnected with the solar cell interconnector according to the invention. Merely the interconnector has to be turned upside down at contact spot 223 in the protected area underneath the cell, as shown in Fig. 4B. This can be easily achieved due to the flexible nature of the interconnector. The contact area around contact spot 223 is shown in more detail in Fig. 4C depicting a planar view onto the cell rear side. Therefore, the cell rear side metallisation layer 204 and the metal layer 221 of the interconnector 202 is visible.

The upside down transfer of the solar cell interconnector 202 is done by folding the interconnector under 45°, which brings the interconnector metal layer 221 in contact with the cell metallisation layer 204, and the "KAPTON" substrate layer 220 to the front. The same connecting technology, i.e. placing welding spots 235 onto the interconnector 202, can be used as on the cell front side contacts.

The 45° folding can be performed in two ways. By folding the metal layer 221 side onto the metal layer side (lower example in Fig. 4C at 225) or alternatively by folding the "KAPTON" substrate layer 220 side onto the "KAPTON" substrate layer side (upper example in Fig. 4C at 224). While both possibilities are feasible, the 45° bend 228, 229 puts significant stresses onto the metal layer 221, which are tensile in the case of the upper example at 224 and which are compressive in the case of the lower example at 225. In the case of the upper example at 224 there is a higher risk that the electrical conduction continuity of the metal layer 221 is affected than in the case of the lower example at 225. In addition the folding according to the lower example (at 225) has the additional advantage, that the electrical conduction continuity can be ensured by an additional connecting spot 227 using the same technique as for the attachment to the cell rear side with welding spots 235. At the additional welding spot 227 the metal layer of the bent portion is in physical contact with the metal layer 221 of the remaining portion of connector 202

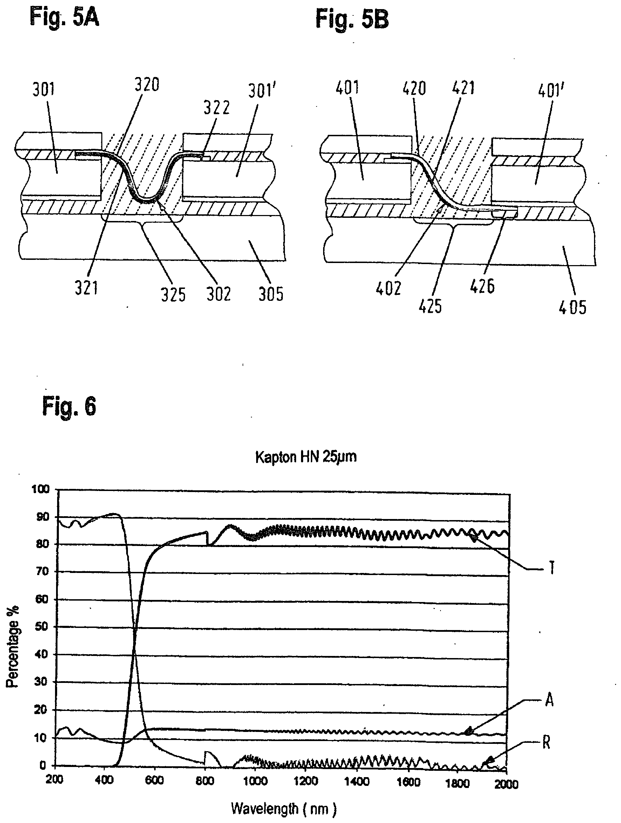

Due to the superior fatigue resistance of the solar cell interconnector according to the present invention, also an encapsulated configuration becomes possible, as illustrated in Fig. 5A and Fig. 5B.

In these examples the entire gap 325, 425 between two solar cells 301, 301'; 401, 401' is filled with a filling material, for example with a lay down silicone adhesive with which the solar cells are mounted to a substructure 305, 405 or with a cover glass adhesive with which the cover glasses are mounted to the solar cells. In these examples the whole solar cell interconnectors 302, 402 are embedded in the filling material including the interconnector 302, 402. In this example the electric connection of the metal layer 321, 421 of the interconnector 302, 402 is carried out as described with respect to Fig. 4A and Fig. 4B with the polymer layer 320, 420 protecting the metal layer 321, 421 against the ions S and with the shadowing at protected space 426.

In order to aid in stress relaxation, the solar cell interconnector can also be patterned in the gap along an axis parallel to the welding pad, which increases its effective length. The encapsulated configuration has the advantage that the silicone adhesive provides an effective protection against atomic oxygen found in low earth orbit applications.

In order for the material combination of the interconnector according to the present invention to become suitable for use as a solar cell interconnector, an appropriate connection method of the metallic electrically conductive layer to the metallised contact pads on the solar cell is required. Laser transmission micro joining, which makes use of the optical characteristics of polyimide, is a suitable state of the art method to achieve this. Fig. 6 shows the measured transmission T, reflection R and absorption A of a 25 $\mu$m "KAPTON HN" foil. The absorption has been calculated from the measurement results.

Oscillations that can be found from 800 nm to higher wavelengths are due to film thickness oscillations. The step inside the curves that can be found directly at 800 nm is a measurement artefact from the setup which was used. From the measurement it can be concluded, that for infrared wavelengths > 700 nm nearly no absorption takes place inside the measured "KAPTON" foil (below 5%). About 85% of incident infrared light is transmitted through the foil.

If the foil is coated with a suitable metal like it is the case with the interconnector according to this invention as shown in Fig. 2, light that is transmitted through the polyimide foil can be absorbed by the metal layer without damaging the polyimide layer (by choosing the right set of parameters). With this principle, a laser welding process with a suitable wavelength, for example 1064 nm as for standard lasers available on the market, can be applied to connect the solar cell interconnector of this invention with the solar cell contacts. For this method, the undercoating (if provided for adhesion enhancement) can also be chosen adequately to enhance the absorption in the metal layer and hence ease the welding process. This can be realized, for example, by applying a 10 to 15 nm layer of NiCr between the polyimide layer and the electrically conductive layer (e.g. Ag layer), as for example suggested in US 6 983 539.

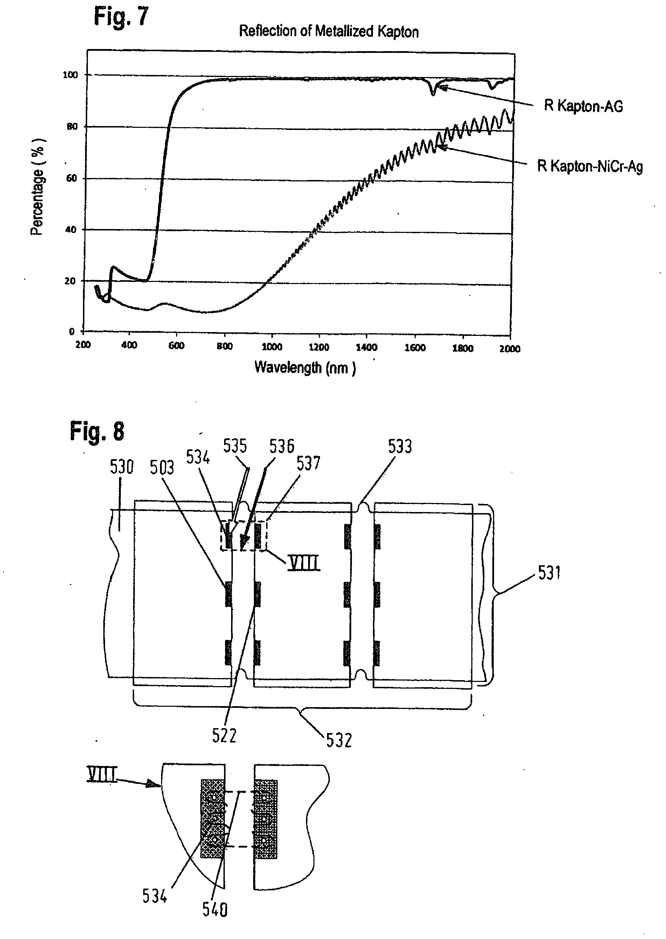

Fig. 7 shows a diagram representing reflection measurements on metallised "KAPTON" from the "KAPTON" layer side. The undercoating of 15 nm CrNi enhances the absorption significantly. Interconnectors have been prepared based on 25 $\mu$m "KAPTON" and 2 $\mu$m Ag with and without a 15 nm CrNi undercoating layer. In Fig. 7 the reflectance is plotted, measured from the "KAPTON" side. The CrNi undercoating layer reduces the reflectance of the metal layer significantly, i.e. increases the desired absorption.

These measurements demonstrate that the solar cell interconnector according to the present invention is compatible with laser transmission welding. The suitability of this method for joining a metallised foil-substrate-combination to another metal is described in the prior art as mentioned earlier.

Fig. 8 shows an automated interconnection method based on the new solar cell interconnector concept. The solar cell interconnector according to the present invention is suitable for an automated interconnection process in which the metalized "KAPTON" foil is provided on a roll 530, in a width covering at least the width of one welding pad 503, 522, ideally the width of the entire cell 531 or the width of several strings of solar cells adjacent to each other. This foil is placed on the string of solar cells 532 with appropriate stress relief loops 533 in between the cells if required. At certain areas on the contact pad 534 the electrical connection to the contact pads is provide via laser joining 535 as outlined above. Afterwards a second laser 536 with appropriate wavelength, pulse energy and duration, is used to cut the desired lateral interconnector shape 537 out of the foil, which is then removed. The laser cut does not necessarily have to penetrate the metallised layer. Only a perforation is required in order to tear off the unwanted material without sacrificing the integrity of the interconnector welds. Depending on the specific needs, complex interconnector shapes 540 are possible, which for example provide individual "fingers" around the welding spots 534. This specific configuration is standard for metal interconnectors and results in a higher reliability, since a failing weld does not sacrifice the neighbouring welds. This automated interconnection is illustrated schematically in Fig. 8.

A necessary precondition that the solar cell interconnector according to the present invention can be used according to an intended purpose in space is its compatibility with the space environment. "KAPTON" and other polyimide films, like e.g. "UPILEX-S", have been already widely used in space and are therefore well characterized, mainly in applications like thermal shields or electrically insulating foils. From this experience the compatibility of "KAPTON" with most space environmental effects can be concluded. The most degrading effect in space is charged particle radiation (protons, electrons). In the interconnector system "KAPTON" takes the role of mechanically stressed supporting film. Therefore it is vital to ensure that even after being exposed to the cumulated radiation dose over mission lifetime, its mechanical properties still remain sufficient.

For polymers the amount of material damage, either cross linking or chain scission, depends on the total ionizing dose deposited in the material. For a typical 15 year mission in geostationary orbit, a dose in the $10^8$ Gy range is expected at the material surface, which decreases to $10^7$ Gy at a "KAPTON" depth of 1 $\mu$m due to internal shielding and then further by a factor 2 to 3 in the next 10 $\mu$m. For material testing on earth, usually completely penetrating radiation, in the form of gamma radiation or electrons are used, which deposit a constant dose across the entire depth of the material. This provides decidedly worst case values.

Data for the mechanical characteristics of "KAPTON" after radiation exposure are available up to a total dose

of $10^7$ Gy as summarized in Table 2. The measurement was performed with a $Co^{60}$ source. For a radiation dose of $10^7$ Gy the tensile strength is reduced by approximately 27% and the elongation by about 48%, whereas the Young's modulus remains almost constant.

**Table 2: Effect of gamma radiation exposure on Kapton PI film (Co60 source, Oak Ridge)**

| 1) | 25μm control film, 0 Gy | $10^4$ Gy, 1h | $10^5$ Gy, 10h | $10^6$ Gy, 4d | $10^7$ Gy, 42d |
|---|---|---|---|---|---|
| Tensile Strength Rm (MPa) | 207 | 207 | 214 | 214 | 152 |
| Elongation ε (%) | 80 | 78 | 78 | 79 | 42 |
| Young's Modulus E (GPa) | 3.172 | 3.275 | 3.378 | 3.275 | 2.903 |
| Volume Resistivity p ($10^{13}$ Ωcm @ 200°C) | 4.8 | 6.6 | 5.2 | 1.7 | 1.6 |
| 1) Dupont Kapton HN Data Sheet | | | | | |

In order to cover a dose of $10^8$ Gy not included in these literature values a "KAPTON VN" foil, 100 μm thick; irradiated with 1 MeV electrons up to a cumulated dose of 7.9 x $10^7$ Gy as exit window of the van de Graaff accelerator at TU Delft, was submitted to mechanical characterization together with a control film of the same material. Four samples were investigated per test. The results are shown as average values in Table 3.

**Table 3: Mechanical Characterization of 100μ Kapton VN after exposure to 7.9 x 107Gy**

| Mechanical Characterization of 100μ Kapton VN (Dupont) after 7.9 x $10^7$ Gy (1 MeV e-) | | | | |
|---|---|---|---|---|
| | Tensile Strength **Rm** (MPa) | Yield Strength at 3% Elongation **Rp3** (MPa) | Elongation ε (%) | Young's Modulus **E** (GPa) |
| Control film, 0 Gy | 223.4 | 74.9 | 60.5 | 3.5 |
| After 7.9 x $10^7$ Gy | 160.9 | 94.4 | 16.1 | 4.4 |
| **Delta (%)** | **-28.0** | **+26.1** | **-73.3** | **+25.0** |

While the tensile strength Rm decreases, the yield strength Rp at 3% elongation increases by almost the same percentage value. More importantly, since the Young's modulus increases by the same amount, the ratio of yield strength to Young's modulus remains constant and therefore the mechanical properties of "KAPTON" even after $10^8$ Gy exposure can be considered sufficient for use as an interconnector.

Finally in space the solar cell interconnectors and the solar cell array according to the invention can be exposed to temperatures enveloping -200 °C to +200 °C. For both layer components of the interconnector, these temperatures are easily tolerable. "KAPTON" is used in a wide range from -269°C to 400°C and the metal film typically can tolerate even higher temperatures. For the assembly of both materials it is desirable not to introduce additional stresses in the interconnector by a large difference in thermal expansion coefficient. Suitable material combinations, however, are readily available. A 25 μm "KAPTON HN" film, for example, with a thermal expansion coefficient of 17 x $10^{-6}$ / K is matched closely to Ag with a thermal expansion coefficient of 19.7 x $10^{-6}$ / K.

**Claims**

1. A solar cell array comprising:

   a first solar cell (101, 201, 301, 401) having a front surface exposed to an ion source (S) and a front contact spot (222) on a front side metallization layer (203);
   a second solar cell (101', 201', 301', 401') having a front surface exposed to the ion source (S) and a rear contact spot (223) on a rear side metallization layer (204); and
   a solar cell interconnector (2', 102, 202, 301, 402) with at least two layers, comprising:

a substrate layer (20, 120, 220, 320, 420) made of polyimide or ETFE; and

an electrically conductive layer (21, 121, 221, 321, 421), consisting of a metal material deposited on the substrate layer (20, 120, 220, 320, 420), wherein:

the substrate layer (20, 120, 220, 320, 420) of the interconnector (102; 202; 302; 402) is directed to the ion source (S) and forms an outer exposed surface area shielding the electrically conductive layer (21, 121, 221, 321, 421) underneath from erosion due to sputtering,

one end portion of the interconnector (2', 102, 202, 301, 402) is turned upside down by folding the interconnector (2', 102, 202, 301, 402) under 45°, so that the electrically conductive layer (21, 121, 221, 321, 421) is folded onto the electrically conductive layer (21, 121, 221, 321, 421) itself,

the one end portion is arranged at the rear contact spot (223) of the second solar cell (101', 201', 301', 401') in a protected space (226) on the rear side of the second solar cell (101', 201', 301', 401'), where the one end portion is protected against impinging ions from the ion source (S), and

the interconnector (2', 102, 202, 301, 402) electrically connects the first solar cell (101, 201, 301, 401) with the second solar cell (101', 201', 301', 401') by being welded with the electrically conductive layer (21, 121, 221, 321, 421) at welding spots (222) to the front contact spot (222) of the first solar cell (101, 201, 301, 401) and at welding spots (235) to the rear contact spot (223) of the second solar cell (101', 201', 301', 401').

2. A solar cell array according to claim 1,
**characterized in that** the material of the substrate layer (20, 120, 220, 320, 420) is polyimide being transmissive for laser light of a wavelength greater than 800 nm, preferably 1064 nm.

3. A solar cell array according to claim 1 or 2,
**characterized in that** the material of the substrate layer (20, 120, 220, 320, 420) comprises high yield strength properties, in particular a yield strength > 100 MPa.

4. A solar cell array according to one of the preceding claims,
**characterized in that** the material of the substrate layer (20, 120, 220, 320, 420) comprises a low Young's modulus, in particular a Young's modulus < 10 MPa.

5. A solar cell array according to one of the preceding claims,
**characterized in that** the metal material of the electrically conductive layer (21, 121, 221, 321, 421) comprises a low electrical resistivity, in particular a resistivity < 5x10-6 Ohm.

6. A solar cell array according to one of the preceding claims,
**characterized in that** the substrate layer is resistant against particle radiation and/or ultraviolet light radiation and/or vacuum exposure.

7. A solar cell array according to one of the preceding claims,
**characterized in that** the material of the electrically conductive layer (21, 121, 221, 321, 421) is selected such that the thermal expansion coefficient of the electrically conductive layer (21, 121, 221, 321, 421) is substantially the same as the thermal expansion coefficient of the substrate layer (20, 120, 220, 320, 420).

8. A solar cell array according to one of the preceding claims,
**characterized in that** the material of the electrically conductive layer (21, 121, 221, 321, 421) is Ag or Au or Au88/Ge12 or Al.

9. A solar cell array according to one of the preceding claims,
**characterized in that** the substrate layer thickness is within a range of 5 to 50 $\mu$m, preferably within a range of 10 to 25 $\mu$m, most preferably 12.5 $\mu$m.

10. A solar cell array according to one of the preceding claims,
**characterized in that** the electrically conductive layer thickness is within a range of 1 to 10 $\mu$m, more preferably within a range of 1 to 5 $\mu$m.

11. A solar cell array according to claim 10,
**characterized in that** the electrically conductive layer thickness is selected in order to minimize stresses in the electrically conductive layer (21, 121, 221, 321, 421) for a given bending radius,
wherein, preferably, the electrically conductive layer thickness is 1.9 μm for a substrate layer thickness of 12.5 μm.

**12.** A solar cell array according to claim 11,
**characterized in that** the solar cell interconnector (302; 402) is embedded in silicone.

**13.** A method of interconnecting solar cells of a solar cell array according to one of the preceding claims, the method comprising the steps:

- providing a sandwich foil roll (530) of a polymeric material substrate layer and an electrically conductive metal layer;
- welding a first spot (222) of the electrically conductive metal layer to a first solar cell contact pad (534) of a first solar cell, so that the substrate layer (20, 120, 220, 320, 420) is directed to an ion source (S) and forms an outer exposed surface area shielding the electrically conductive metal layer (21, 121, 221, 321, 421) underneath from erosion due to sputtering;
- laser cutting (537) the polymeric material substrate layer on a side remote from the first welding spot (222);
- tearing off of the remaining sandwich foil and thus cutting the metal layer, thereby forming a solar cell interconnector (2', 102, 202, 301, 402);
- turning one end portion of the solar cell interconnector (2', 102, 202, 301, 402) upside down by folding the interconnector (2', 102, 202, 301, 402) under 45°, so that the electrically conductive metal layer (21, 121, 221, 321, 421) is folded onto the electrically conductive metal layer (21, 121, 221, 321, 421) itself;
- arranging the one end portion at a second solar cell contact pad (223) of the second solar cell (101', 201', 301', 401') in a protected space (226) on a rear side of a second solar cell (101', 201', 301', 401'), where the one end portion is protected against impinging ions from the ion source (S); and
- welding a second spot (235) of the electrically conductive metal layer to the second solar cell contact pad (223).

**14.** The method according to claim 13, further comprising:

- welding an additional connecting spot (227) where the electrically conductive metal layer of the interconnector is in physical contact with the electrically conductive metal layer itself.

**15.** The method according to claim 13 or 14, wherein the welding of the first spot (222), the second spot (223, 235) and the additional connecting spot (227) is performed by a laser having a wavelength greater than 800 nm, preferably 1064 nm.

**Patentansprüche**

**1.** Solarzellenanordnung, umfassend:

eine erste Solarzelle (101, 201, 301, 401) mit einer einer Ionenquelle (S) ausgesetzten Vorderseite und einer Frontkontaktstelle (222) auf einer frontseitigen Metallisierungsschicht (203);
eine zweite Solarzelle (101', 201', 301', 401') mit einer der Ionenquelle (S) ausgesetzten Vorderseite und einer rückseitigen Kontaktstelle (223) auf einer rückseitigen Metallisierungsschicht (204); und
ein Solarzellenverbinder (2', 102, 202, 301, 402) mit mindestens zwei Schichten, umfassend:

eine Substratschicht (20, 120, 220, 320, 420) aus Polyimid oder ETFE; und
eine elektrisch leitende Schicht (21, 121, 221, 321, 421), bestehend aus einem Metallmaterial, das auf der Substratschicht (20, 120, 220, 320, 420) aufgetragen ist,

wobei:

die Substratschicht (20, 120, 220, 320, 420) des Verbinders (102; 202; 302; 402) der Ionenquelle (S) zugewandt ist und einen äußeren exponierten Oberflächenbereich bildet, der die darunter liegende elektrisch leitende Schicht (21, 121, 221, 321, 421) vor Erosion durch Sputtern abschirmt,
ein Endabschnitt des Verbinders (2', 102, 202, 301, 402) umgedreht wird, indem der Verbinder (2', 102, 202, 301, 402) unter 45° gefaltet wird, so dass die elektrisch leitende Schicht (21, 121, 221, 321, 421) auf die elektrisch leitende Schicht (21, 121, 221, 321, 421) selbst gefaltet wird,

der eine Endabschnitt an der rückseitigen Kontaktstelle (223) der zweiten Solarzelle (101', 201', 301', 401') in einem geschützten Raum (226) auf der Rückseite der zweiten Solarzelle (101', 201', 301', 401') angeordnet ist, wo der eine Endabschnitt vor auftreffenden Ionen von der Ionenquelle (S) geschützt ist, und der Verbinder (2', 102, 202, 301, 402) die erste Solarzelle (101, 201, 301, 401) mit der zweiten Solarzelle (101', 201', 301', 401') elektrisch verbindet, indem er mit der elektrisch leitfähigen Schicht (21, 121, 221, 321, 421) an Schweißpunkten (222) mit der vorderen Kontaktstelle (222) der ersten Solarzelle (101, 201, 301, 401) und an Schweißpunkten (235) mit der hinteren Kontaktstelle (223) der zweiten Solarzelle (101', 201', 301', 401') verbunden ist.

2. Solarzellenanordnung gemäß Anspruch 1,
   **dadurch gekennzeichnet, dass** das Material der Substratschicht (20, 120, 220, 320, 420) Polyimid ist, das für Laserlicht mit einer Wellenlänge größer als 800 nm, vorzugsweise 1064 nm, durchlässig ist.

3. Solarzellenanordnung gemäß Anspruch 1 oder 2,
   **dadurch gekennzeichnet, dass** das Material der Substratschicht (20, 120, 220, 320, 420) hohe Streckgrenzeigenschaften aufweist, insbesondere eine Streckgrenze > 100 MPa.

4. Solarzellenanordnung gemäß einem der vorhergehenden Ansprüche,
   **dadurch gekennzeichnet, dass** das Material der Substratschicht (20, 120, 220, 320, 420) einen niedrigen Elastizitätsmodul, insbesondere einen Elastizitätsmodul < 10 MPa aufweist.

5. Solarzellenanordnung gemäß einem der vorhergehenden Ansprüche,
   **dadurch gekennzeichnet, dass** das Metallmaterial der elektrisch leitfähigen Schicht (21, 121, 221, 321, 421) einen geringen elektrischen Widerstand, insbesondere einen spezifischen Widerstand < 5x10-6 Ohm, aufweist.

6. Solarzellenanordnung gemäß einem der vorhergehenden Ansprüche,
   **dadurch gekennzeichnet, dass** die Substratschicht resistent gegen Teilchenstrahlung und/oder Ultraviolettlichtstrahlung und/oder Vakuumeinwirkung ist.

7. Solarzellenanordnung gemäß einem der vorhergehenden Ansprüche,
   **dadurch gekennzeichnet, dass** das Material der elektrisch leitenden Schicht (21, 121, 221, 321, 421) so gewählt ist, dass der Wärmeausdehnungskoeffizient der elektrisch leitenden Schicht (21, 121, 221, 321, 421) im Wesentlichen der gleiche ist wie der Wärmeausdehnungskoeffizient der Substratschicht (20, 120, 220, 320, 420).

8. Solarzellenanordnung gemäß einem der vorhergehenden Ansprüche,
   **dadurch gekennzeichnet, dass** das Material der elektrisch leitenden Schicht (21, 121, 221, 321, 421) Ag oder Au oder Au88/Ge12 oder Al ist.

9. Solarzellenanordnung gemäß einem der vorhergehenden Ansprüche,
   **dadurch gekennzeichnet, dass** die Substratschichtdicke in einem Bereich von 5 bis 50 $\mu$m, vorzugsweise in einem Bereich von 10 bis 25 $\mu$m, am meisten bevorzugt 12,5 $\mu$m, liegt.

10. Solarzellenanordnung gemäß einem der vorhergehenden Ansprüche,
    **dadurch gekennzeichnet, dass** die elektrisch leitende Schichtdicke in einem Bereich von 1 bis 10 $\mu$m, besonders bevorzugt in einem Bereich von 1 bis 5 $\mu$m liegt.

11. Solarzellenanordnung gemäß Anspruch 10,
    **dadurch gekennzeichnet, dass** die Dicke der elektrisch leitenden Schicht so gewählt ist, dass die Spannungen in der elektrisch leitenden Schicht (21, 121, 221, 321, 421) für einen gegebenen Biegeradius minimiert werden, wobei vorzugsweise die elektrisch leitfähige Schichtdicke 1,9 $\mu$m bei einer Substratschichtdicke von 12,5 $\mu$m beträgt.

12. Solarzellenanordnung gemäß Anspruch 11,
    **dadurch gekennzeichnet, dass** der Solarzellenverbinder (302; 402) in Silikon eingebettet ist.

13. Verfahren zum Verbinden von Solarzellen einer Solarzellenanordnung nach einem der vorhergehenden Ansprüche, wobei das Verfahren die Schritte umfasst:

    - Bereitstellen einer Sandwich-Folienrolle (530) aus einer Substratschicht aus polymerem Material und einer elektrisch leitenden Metallschicht;

- Verschweißen eines ersten Punktes (222) der elektrisch leitenden Metallschicht mit einem ersten Solarzellen-Kontaktpad (534) einer ersten Solarzelle, so dass die Substratschicht (20, 120, 220, 320, 420) auf eine Ionenquelle (S) gerichtet ist und einen äußeren exponierten Oberflächenbereich bildet, der die darunter liegende elektrisch leitende Metallschicht (21, 121, 221, 321, 421) vor Erosion durch Sputtern abschirmt;

- Laserschneiden (537) der Substratschicht aus polymerem Material auf einer von dem ersten Schweißpunkt (222) abgewandten Seite;

- Abreißen der restlichen Sandwich-Folie und damit Durchtrennen der Metallschicht, wodurch ein Solarzellenverbinder (2', 102, 202, 301, 402) entsteht;

- Umdrehen eines Endabschnitts des Solarzellenverbinders (2', 102, 202, 301, 402) durch Falten des Verbinders (2', 102, 202, 301, 402) unter 45°, so dass die elektrisch leitende Metallschicht (21, 121, 221, 321, 421) auf die elektrisch leitende Metallschicht (21, 121, 221, 321, 421) selbst gefaltet wird;

- Anordnen des einen Endabschnitts an einem zweiten Solarzellenkontaktpad (223) der zweiten Solarzelle (101', 201', 301', 401') in einem geschützten Raum (226) auf einer Rückseite einer zweiten Solarzelle (101', 201', 301', 401'), wo der eine Endabschnitt gegen auftreffende Ionen von der Ionenquelle (S) geschützt ist; und

- Verschweißen eines zweiten Punktes (235) der elektrisch leitenden Metallschicht mit dem zweiten Solarzellenkontaktpad (223).

**14.** Verfahren gemäß Anspruch 13, ferner umfassend:

- Schweißen eines zusätzlichen Verbindungspunktes (227), an dem die elektrisch leitende Metallschicht des Verbinders in physischem Kontakt mit der elektrisch leitenden Metallschicht selbst steht.

**15.** Verfahren gemäß Anspruch 13 oder 14, wobei das Schweißen des ersten Punktes (222), des zweiten Punktes (223, 235) und des zusätzlichen Verbindungspunktes (227) durch einen Laser mit einer Wellenlänge größer als 800 nm, vorzugsweise 1064 nm, durchgeführt wird.

## Revendications

**1.** Réseau de cellules solaires comprenant :

une première cellule solaire (101, 201, 301, 401) ayant une surface avant exposée à une source d'ions (S) et un point de contact avant (222) sur une couche de métallisation côté avant (203) ;
une deuxième cellule solaire (101', 201', 301', 401') ayant une surface avant exposée à la source d'ions (S) et un point de contact arrière (223) sur une couche de métallisation arrière (204) ; et
un interconnecteur de cellules solaires (2', 102, 202, 301, 402) avec au moins deux couches, comprenant :

une couche de substrat (20, 120, 220, 320, 420) en polyimide ou en ETFE ; et
une couche électriquement conductrice (21, 121, 221, 321, 421), constituée d'un matériau métallique déposé sur la couche de substrat (20, 120, 220, 320, 420), dans laquelle :

la couche de substrat (20, 120, 220, 320, 420) de l'interconnecteur (102 ; 202 ; 302 ; 402) est dirigée vers la source d'ions (S) et forme une surface extérieure exposée protégeant la couche électriquement conductrice (21, 121, 221, 321, 421) en dessous de l'érosion due à la pulvérisation,
une partie d'extrémité de l'interconnecteur (2', 102, 202, 301, 402) est retournée à l'envers en pliant l'interconnecteur (2', 102, 202, 301, 402) sous 45°, de sorte que la couche électriquement conductrice (21, 121, 221, 321, 421) est repliée sur la couche électriquement conductrice (21, 121, 221, 321, 421) elle-même,
la première partie d'extrémité est agencée au niveau du point de contact arrière (223) de la deuxième cellule solaire (101', 201', 301', 401') dans un espace protégé (226) sur la face arrière de la deuxième cellule solaire (101', 201', 301', 401'), où la première partie d'extrémité est protégée contre les ions incidents provenant de la source d'ions (S), et
l'interconnecteur (2', 102, 202, 301, 402) connecte électriquement la première cellule solaire (101, 201, 301, 401) avec le deuxième cellule solaire (101', 201', 301', 401') en étant soudé avec la couche électriquement conductrice (21, 121, 221, 321, 421) au niveau de points de soudure (222) au point de contact avant (222) de la première cellule solaire (101, 201, 301, 401) et au niveau de points de soudure (235) au point de contact arrière (223) de la deuxième cellule solaire (101', 201', 301', 401').

**2.** Réseau de cellules solaires selon la revendication 1,
**caractérisé en ce que** le matériau de la couche de substrat (20, 120, 220, 320, 420) est du polyimide étant transmissif pour une lumière laser d'une longueur d'onde supérieure à 800 nm, de préférence 1 064 nm.

**3.** Réseau de cellules solaires selon la revendication 1 ou 2,
**caractérisé en ce que** le matériau de la couche de substrat (20, 120, 220, 320, 420) comporte des propriétés de limite d'élasticité élevée, en particulier une limite d'élasticité > 100 MPa.

**4.** Réseau de cellules solaires selon l'une des revendications précédentes,
**caractérisé en ce que** le matériau de la couche de substrat (20, 120, 220, 320, 420) comporte un module d'Young faible, en particulier un module d'Young
< 10 MPa.

**5.** Réseau de cellules solaires selon l'une des revendications précédentes,
**caractérisé en ce que** le matériau métallique de la couche électriquement conductrice (21, 121, 221, 321, 421) comporte une faible résistivité électrique, en particulier une résistivité < 5 x 10-6 Ohm.

**6.** Réseau de cellules solaires selon l'une des revendications précédentes,
**caractérisé en ce que** la couche de substrat est résistante au rayonnement de particules et/ou au rayonnement de lumière ultraviolette et/ou à l'exposition au vide.

**7.** Réseau de cellules solaires selon l'une des revendications précédentes,
**caractérisé en ce que** le matériau de la couche électriquement conductrice (21, 121, 221, 321, 421) est choisi de telle sorte que le coefficient de dilatation thermique de la couche électriquement conductrice (21, 121, 221, 321, 421) soit sensiblement le même que le coefficient de dilatation thermique de la couche de substrat (20, 120, 220, 320, 420).

**8.** Réseau de cellules solaires selon l'une des revendications précédentes,
**caractérisé en ce que** le matériau de la couche électriquement conductrice (21, 121, 221, 321, 421) est de l'Ag ou de l'Au ou de l'Au88/Ge12 ou de l'Al.

**9.** Réseau de cellules solaires selon l'une des revendications précédentes,
**caractérisé en ce que** l'épaisseur de la couche de substrat se situe dans une plage de 5 à 50 $\mu$m, de préférence dans une plage de 10 à 25 $\mu$m, le plus préférablement de 12,5 $\mu$m.

**10.** Réseau de cellules solaires selon l'une des revendications précédentes,
**caractérisé en ce que** l'épaisseur de la couche électriquement conductrice se situe dans une plage de 1 à 10 $\mu$m, plus préférablement dans une plage de 1 à 5 $\mu$m.

**11.** Réseau de cellules solaires selon la revendication 10,
**caractérisé en ce que** l'épaisseur de la couche électriquement conductrice est choisie afin de réduire au minimum les contraintes dans la couche électriquement conductrice (21, 121, 221, 321, 421) pour un rayon de courbure donné, dans lequel, de préférence, l'épaisseur de la couche électriquement conductrice est de 1,9 $\mu$m pour une épaisseur de couche de substrat de 12,5 $\mu$m.

**12.** Réseau de cellules solaires selon la revendication 11,
**caractérisé en ce que** l'interconnecteur de cellules solaires (302 ; 402) est noyé dans de la silicone.

**13.** Procédé d'interconnexion de cellules solaires d'un réseau de cellules solaires selon l'une des revendications précédentes, le procédé comprenant les étapes de :

- fournir un rouleau de feuille sandwich (530) d'une couche de substrat en matériau polymère et d'une couche métallique électriquement conductrice ;
- souder un premier point (222) de la couche métallique électriquement conductrice à un premier plot de contact de cellule solaire (534) d'une première cellule solaire, de sorte que la couche de substrat (20, 120, 220, 320, 420) soit dirigée vers une source d'ions (S) et forme une surface extérieure exposée protégeant la couche métallique électriquement conductrice (21, 121, 221, 321, 421) en dessous de l'érosion due à la pulvérisation cathodique ;

- découpe au laser (537) de la couche de substrat en matériau polymère sur un côté éloigné du premier point de soudure (222) ;
- arracher la feuille sandwich restante et couper ainsi la couche métallique, formant ainsi un interconnecteur de cellules solaires (2', 102, 202, 301, 402) ;
- retourner une partie d'extrémité de l'interconnecteur de cellules solaires (2', 102, 202, 301, 402) à l'envers en pliant l'interconnecteur (2', 102, 202, 301, 402) sous 45°, de sorte que la couche métallique électriquement conductrice (21, 121, 221, 321, 421) soit repliée sur la couche métallique électriquement conductrice (21, 121, 221, 321, 421) elle-même ;
- disposer la première partie d'extrémité au niveau d'un deuxième plot de contact de cellule solaire (223) de la deuxième cellule solaire (101', 201', 301', 401') dans un espace protégé (226) sur un côté arrière d'une deuxième cellule solaire (101', 201', 301', 401'), où la première partie d'extrémité est protégée contre les ions incidents provenant de la source d'ions (S) ; et
- souder un deuxième point (235) de la couche métallique électriquement conductrice au deuxième plot de contact de cellule solaire (223).

14. Procédé selon la revendication 13, comprenant en outre :

- le soudage d'un point de connexion supplémentaire (227) où la couche métallique électriquement conductrice de l'interconnecteur est en contact physique avec la couche métallique électriquement conductrice elle-même.

15. Procédé selon la revendication 13 ou 14, dans lequel le soudage du premier point (222), du deuxième point (223, 235) et du point de connexion supplémentaire (227) est réalisé par un laser ayant une longueur d'onde supérieure à 800 nm, de préférence 1 064 nm.

**Fig. 1**

**Fig. 2**

## Fig. 3A

L

| Ag | X |
| Kapton | DKapton |

## Fig. 3B

L

Ag

N.A:

Ag Y

L'

## Fig. 4A

S

103 101 102 120 121 122' 101' 103'

122

## Fig. 4B

S

203 201 220 202 221 223 201'

222

226 204

C

## Fig. 4C

202 221 229 204

224 220

221 235

225 220

228

227

202

## Fig. 5A

## Fig. 5B

## Fig. 6

Kapton HN 25μm

## Fig. 7

Reflection of Metallized Kapton

R Kapton-AG

R Kapton-NiCr-Ag

## Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0758145 A2
- EP 1305988 A1
- US 6983539 B2
- US 2007283997 A1
- US 2013048336 A1
- US 3553030 A
- US 6184457 B1
- US 2008314432 A1
- US 4562637 A
- US 2009159119 A1
- US 5391235 A
- DE 102008050332 A1
- EP 1693899 A2
- US 6983539 B

**Non-patent literature cited in the description**

- **M. TARTZ ; T. HEYN ; C. BUNDESMANN ; C. ZIMMERMANN ; H. NEUMANN.** Sputter yields of Mo, Ti, W, Al, Ag under xenon ion incidence. *Eur. Phys. J. D,* 2011, vol. 61, 587-592
- ASM International Metals Handbook. vol. 2
- **A.P. YALIN ; B. RUBIN ; S.R. DOMINGUE ; Z. GLUECKERT ; J.D. WILLIAMS.** *Differential Sputter Yields Of Boron Nitride, Quartz, and Kapton Due to Low Energy Xe+ Bombardment, 43rd AIAA/ASME/SAE/ASEE Joint Propulsion Conference & Exhibit*